# EUROPEAN PATENT APPLICATION

(11) **EP 0 883 026 A1**
(43) Date of publication of application: **09.12.1998**
(21) Application number: 98201775.8
(22) Date of filing: 28.05.1998
(51) Int. Cl.: G03F 7/00, B41C 1/14, B41C 1/02

(54) **Method of forming an image**

(30) Priority: 04.06.1997 GB 9711425
(71) Applicant: EASTMAN KODAK COMPANY, Rochester, New York 14650 (US)
(72) Inventor: Simons, Michael John, Harrow HA1 4TY (GB); Sharman, Richard, Harrow HA1 4TY (GB)
(74) Representative: Nunney, Ronald Frederick Adolphe

(57) **Abstract**

The method relates to a method of forming an image comprising providing a coating of a cross-linkable polymeric substance on a substrate , applying a pattern of cross-linker to said coated substrate by ink jet printing to cross-link said polymeric substance in the pattern of the crosslinker, and washing the coated substrate to remove cross-linkable polymer in the area not having the pattern of cross-linker applied thereto.

## Description

### Field of the Invention

The invention relates to forming an image by selectively crosslinking a substrate by ink jet printing a crosslinker onto to a crosslinkable polymeric substrate.

### Background of the Invention

It has been known to form images by selectively crosslinking materials by applying light to a cross-linkable resin. The technique has been used for forming photoresists where after uncrosslinked material has been removed etching of metal or glass is carried out. The technique has also been used to form silk-screen or screen-printing materials where the uncrosslinked material is washed out of the screen to create the finished printing screen. Such techniques are disclosed in "Light Sensitive Systems" by J.Kosar, published by John Wiley and Sons, Inc., New York, 1965, and in "Screen Process Printing" by J.Stephens, published by Blueprint (an imprint of Chapman and Hall), London, 1996.

The prior techniques while successful are expensive as they require expensive light imaging apparatus. Further they require expensive resins that will cross-link when exposed to light. There is difficulty in forming thick coats of crosslinked polymer as the light can not penetrate through thick cross-linkable resins, particularly when they are coloured. Further, only very expensive imaging equipment could accurately produce fine quality images.

### Problem to be solved by the Invention

There is a need for a method for forming hardened polymeric images in layers of crosslinkable materials that are accurate and low in cost.

### Summary of the Invention

It is an object of the invention to overcome disadvantages of forming images by the prior methods.

It is another object of the invention to produce low cost and accurate screen printing screens.

These and other objects of the invention are generally accomplished by a method of forming an image comprising providing a coating of a cross-linkable polymeric substance on a substrate, applying a pattern of cross-linker to said coated substrate by ink jet printing to cross-link said polymeric substance, and washing the coated substrate to remove cross-linkable polymer in the area not having cross-linker applied thereto.
In another embodiment the invention provides a method of forming an image comprising providing a coating of a cross-linkable polymeric substance on a foraminous substrate, applying a pattern of cross-linker to said coated substrate by ink jet printing to cross-link said polymeric substance in the pattern of the crosslinker, and washing the coated substrate to remove cross-linkable polymer in the area not having the pattern of cross-linker applied thereto, bringing the washed substrate into contact with a surface, applying an ink to said substrate, and removing said foraminous substrate to leave an image on said surface.

### Advantageous Effect of the Invention

The invention forms accurate low cost silk screen and coloured relief images on a variety of substrates using materials that are not light sensitive.

### Detailed Description of the Invention

The invention has numerous advantages over previous processes of forming crosslinked images in crosslinkable materials. The invention is low in cost and uses the common ink jet printer to create accurate and low cost images. This printing technique allows images to be formed by printing from a computer onto a substrate that does not have to kept in the dark. The substrate may be formed of a dry material such as gelatine that may be easily handled in the light and then washed with water to remove uncross-linked portions. The material does not need to be flat during imaging as in many light exposing techniques.

The method is much simpler to operate than existing decoration or fabrication techniques using light-induced hardening of polymeric layers by light exposure through an optical pattern. It does not involve light-sensitive materials , nor toxic materials like potassium dichromate. It provides a versatile decoration and fabrication technique to anyone with a computer and ink-jet printer fitted with a suitable cartridge, and has the potential to open a wide range of craft applications involving decoration and images to a large number of people. These and other objects will become apparent from the detailed description below.

The invention comprises a process for printing, marking or fabricating images or marks from electronic information by writing by means of an ink-jet printer which deposits in a pattern a cross-linking fluid onto a substrate which bears a layer of cross-linkable or hardenable polymeric material, and then treating the substrate to cause a distribution of hardened crosslinked polymeric material according to the deposited pattern. The pattern in polymeric material may constitute the desired image, or may be subsequently treated for example by dyeing to give the desired image. The image may then be used as a mask for a subsequent process, such as printing or etching.

For example, gelatine has been found to be a suitable cross-linkable polymeric material, and suitable cross-linker fluids for gelatine include aqueous solutions of polyvalent metal salts such as aluminium or chromium (III) sulphates, and/or aqueous solutions of aldehydes such as formaldehyde or glutaraldehyde. After application of the pattern of cross-linking fluid, the unhardened gelatine may be removed by washing with warm (> 35C) water to leave a residual pattern in hardened gelatine, which may contain a dye or pigment, or may be subsequently dyed or pigmented.

In a variant of the method, the substrate may comprise a permeable woven or fibrous material, such as silk fabric, polyester or polyamide mesh, or open-weave paper, in which case a pattern-wise distribution of gelatine will block the interstices between the fibres to allow silk-screen printing through the material onto another substrate.

In a further application, the hardenable polymeric layer may be coated on top of another polymeric layer, such that one layer is water-soluble and the other is solvent-soluble. In the case that the hardenable layer is water-soluble (e.g. gelatine), and the under-layer is solvent-soluble (e.g. cellulose acetate butyrate), a pattern in hardened gelatine may be generated as already described, and the coated material then treated with a solvent (e.g. acetone) which will remove the underlying layer in the areas in which gelatine is not present. If the supporting material which bears the two layers is a metal, such as aluminium, or brass, or copper, an etching solution may then be applied, so as to etch the metal in the areas where the solvent-soluble but water-insoluble polymer has been dissolved away, to leave an etched pattern. If the etching is allowed to extend through the thickness of the metal, then a stencil will result, or the method can be used to make shaped metal components, analogously to the known techniques of photofabrication.

Various other methods of decoration or fabrication based on the general principles of the invention may be envisaged.

Any suitable cross-linkable polymeric material may be used in the invention. Typical materials include polymeric materials having carboxylic acid, amino, hydroxyl, unsaturated or epoxy functional groups. Suitable cross-linkable polymeric materials are gelatine, polymers of acrylic, methacrylic or maleic acid or anhydride or their copolymers with ethylene, styrene or vinyl ethers, and polyamine polymers such as polyethyleneimine. Most preferred is gelatine as it is safe, easily coated, and readily washed off if not cross linked. The gelatine may be present with other polymeric materials, particularly carboxylic acid-containing polymers and gelatine-compatible latexes.

The substrate may be any suitable material for printing with an ink jet printer. Suitable materials include cloth, metal, paper and plastic sheets. If a plastic sheet is used for the substrate is may be any of the common polymer sheet materials such as polyethylene, polypropylene, cellulose acetate and polyester. The use of a fabric or mesh of cloth or metal is preferred as this allows the formation in a low cost manner of a screen-printing screen of high quality.

Any suitable ink jet printer may be used in the invention. The printer must be able to operate with a solution of the crosslinker substituted for the standard ink cartridge. As is known ink jet printers of the "drop on demand" type generally operate by ejecting ink droplets by means of a pressure pulse induced by a piezoelectric impulse or by a thermal pulse ("bubble jet"). Either type of printer is suitable for the invention, provided that the solution of the crosslinker is formulated to have chemical and physical properties, including viscosity and surface tension, appropriate to the printer.

Other types of ink jet printer may also be used, including "continuous working" types which eject a continuous stream of droplets which are deflected by an electrostatic field as required, while other types may use a long array of ink jet nozzles. The transport of the substrate to be printed can be varied to suit. For instance, film or paper substrates can be transported round rollers in the printer in the normal way, but a printing screen held on a frame would require a flat bed transport system so the whole frame can be transported past the print head.

The cross-linker material will depend on what cross-linkable polymeric substance is used in the process. Any material that may be placed in a liquid suitable for use in an ink jet may be used. Many materials are known to act as hardening or crosslinking agents for gelatine, see for example chapter 2 of "The Theory of the Photographic Process", Fourth Edition, edited by T.H.James and published by the Eastman Kodak Company, 1977. Crosslinking agents for gelatine include metal salts, aldehydes, N-methylol compounds, diketone compounds, sulphonate esters and sulphonyl halides, S-triazines, and active olefins including bis-vinyl sulphonyl compounds.

Especially suitable materials as the crosslinker for gelatine include aqueous solutions of aldehydes including formaldehyde, glyoxal and glutaraldehyde; and aqueous solutions of polyvalent metal salts such as Al³⁺, Cr³⁺, Fe³⁺, Ce⁴⁺. The preferred crosslinkers for the gelatines are glutaraldehyde and trivalent metal salts. Also preferred are the aqueous salts of Al(III) and Cr(III), including their chlorides, sulphates and nitrates. The preferred cross-linkers for the carboxylic acid polymers and copolymers are trivalent metal salts. Most preferred are the aqueous salts of Al(III) and Cr(III), including their chlorides, sulphates and nitrates. The preferred crosslinkers for amine-bearing polymers are aldehydes and active vinyl compounds.

The material used in the ink jet cartridge may be any material that is compatible with the crosslinker. The preferred carrier liquid for the crosslinker is water, but other solvents or cosolvents may be present. For the preferred metal salts the solvent would be substantially water. Humectant agents which are commonly present in ink-jet inks may be present, and these include high boiling point liquids such as glycerol, ethylene glycol, diethylene glycol, triethylene glycol and 2-pyrrolidinone, as well as solids with a high affinity for water such as trimethylolpropane. Other substances present in the liquid in the ink jet cartridge may include antibacterial agents and thickening agents. The various substances present in the carrier liquid for the crosslinker must be compatible with the crosslinker and with the ink-jet mechanism.

Other fillers and additives such as known in the art may be used in the polymeric materials of the invention. Typical of such materials are bactericides, fillers , ultraviolet absorbers and brighteners.

The polymeric materials may be coloured before or after ink jet printing. The colorants are those such as anionic dyes such as Tartrazine or Acid Blue 92, cationic dyes such as Rhodamine 6G or Crystal Violet, zwitterionic dyes such as Acid Fuchsin, or finely dispersed pigments such as titanium dioxide or copper phthalocyanine.If colorants are added in a wash after hardening they may be the same or different.

The following examples illustrate the practice of this invention. They are not intended to be exhaustive of all possible variations of the invention. Parts and percentages are by weight unless otherwise indicated.

### Examples

### EXAMPLE 1

This example illustrates the formation of a relief image in partially pre-hardened gelatine, which was subsequently dyed.
A coating was prepared on photographic film base (polyethylene terephthalate film which had been given a standard subbing treatment) of gelatine at a laydown of 8 g per square metre.
A portion of the dried coating was written to with a Hewlett Packard™ Deskjet 850C printer in which the black ink had been replaced in its cartridge by the following solution:

| | |
|---|---|
| Al(NO₃)₃.9H₂O | 5.0 g |
| CrK(SO₄)₂.12H₂O | 5.0 |
| ethylene glycol | 7.5 |
| water | 85.0 |

The ink was allowed to dry, then the printed coating washed for 3 minutes in running water at 40C. It was observed that the gelatine washed away from the unprinted areas, and a relief image of hardened gelatine remained where letters had been printed. The coating was then immersed for 20 seconds in a 1% w/w aqueous solution of the dye Acid Blue 92, rinsed and dried. The printed letters were visible as a blue relief image.

### EXAMPLE 2

This example illustrates screen printing using a polyester chiffon fabric having a square weave with 3 threads per millimetre.
A 10x13 mm window was cut in a piece of 175 micron thick polyester film base, and covered with a piece of the polyester chiffon, which was attached round the edges of the window with glue and adhesive tape. The assembly was immersed in 8% w/w aqueous gelatine solution at 40C, then withdrawn and suspended vertically so that excess gelatine could drain off. It was allowed to dry under ambient conditions, so that a film of dried gelatine was formed in the weave of the fabric.
The gelatine-impregnated fabric was then written to with an ink-jet printer as above, except the hardening ink was of the following composition:

| | |
|---|---|
| Al(NO₃)₃.9H₂O | 5.0 g |
| CrK(SO₄)₂.12H₂O | 5.0 |
| Glutaraldehyde 50% aqueous | 2.0 |
| ethylene glycol | 7.5 |
| water | 83.0 |

The writing was in the form of printed text, between 12 and 18 point size, and was written in a negative sense, so that ink was applied to the background but not to the letters of the text.
The sample was allowed to dry, then held for 20 minutes in an oven at 60C, then washed with running water at 40C, then allowed to dry. It was observed that the gelatine had been washed out from the unhardened areas of the letters, and that hardened gelatine remained in the background areas to which the hardener ink had been applied.
The resulting screen was contacted against a sheet of card, and screen printing ink (Acrylic Based Screen and Fabric Printing Colour by Daler-Rowney) was squeegeed against the screen with a rubber blade. On removing the screen, printed letters where the ink had passed through the screen were observed on the underlying card.

### EXAMPLE 3:

The experiment of Example 2 was repeated, except the fabric used was silk screen fabric having 5 threads per millimetre in one direction and 7 in the orthogonal direction. The sample was stretched in a frame for the printing operation. Printed letters were again formed on the card, the letters having a finer structure than in Example 2.

### EXAMPLE 4:

This example illustrates the practice of the invention on a metal substrate, in this case to form an etched stencil.
A piece of anodised aluminium sheet, of thickness 130 micrometres, as used for making printing plates, was coated with the following solutions by means of a coating knife whose edge was supported 100 micrometres above the anodised surface. The first solution gave a water- and etch- resistant layer containing polyethyleneimine to enable the gelatine of the second layer to bond to it. The gelatine provided a solvent-resistant layer to allow the patternwise removal of the first layer by means of an organic solvent wash.

### Solution 1:

| | |
|---|---|
| Polyvinyl butyral | 5.0 g |
| Polyethyleneimine ("Lupasol FG" from BASF) | 0.25 g |
| Ethanol | 95 g |

The coating was allowed to dry and was then supercoated with:

### Solution 2:

8% aqueous gelatine solution at 40C.
The coating was allowed to dry, cut to size and placed in an ink-jet printer and written to as in Example 2, using the hardener "ink" of Example 2.
The sample was allowed to dry, then held for 20 minutes in an oven at 60C, then washed with running water at 40C, then allowed to dry. It was observed that the gelatine had been washed out from the unhardened areas of the letters, and that hardened gelatine remained in the background areas to which the hardener ink had been applied.
The sample was then washed by agitating in a dish of acetone, until the polyvinyl butyral had been removed from the anodised aluminium surface in the areas from which the gelatine had been removed.
The aluminium was then etched at room temperature, first with 4M sodium hydroxide solution for one minute, then for about 10 minutes with an aqueous solution containing 500 g of hydrated ferric chloride and 30 ml of concentrated hydrochloric acid per kilogram of solution. At the end of the etching time, the letters corresponding to the unhardened areas of the gelatine had been etched right through the metal to form a stencil.

## Claims

1. A method comprising providing a coating of a cross-linkable polymeric substance on a substrate, applying a pattern of cross-linker to said coated substrate by ink jet printing to cross-link said polymeric substance in the pattern of the crosslinker, and washing the coated substrate to remove cross-linkable polymer in the area not having the pattern of cross-linker applied thereto.

2. The method of claim 1 wherein said cross-linkable polymeric substance comprises gelatine.

3. The method of any of claims 1 or 2 wherein said substrate comprises a foraminous member.

4. The method according to claims 1 or 3 wherein said cross-linkable polymeric substance is selected from at least one of the group consisting of polymers of acrylic, methacrylic, maleic acid, maleic anhydride and their copolymers with ethylene, styrene or vinylethers.

5. The method according to any of claims 1 to 4 wherein said cross linker comprises an aqueous solution of metal salt.

6. The method of claims 1-5 wherein the substrate comprises a metal or glass sheet coated with a solvent soluble but not water soluble layer, wherein after said washing the coated substrate is solvent washed to remove the solvent soluble substance, and further comprising treating the metal or glass substrate to etch the substrate.

7. A method of forming an image comprising providing a coating of a cross-linkable polymeric substance on a foraminous substrate, applying a pattern of cross-linker to said coated substrate by ink jet printing to cross-link said polymeric substance in the pattern of the crosslinker, and washing the coated substrate to remove cross-linkable polymer in the area not having the pattern of cross-linker applied thereto, bringing the washed substrate into contact with a surface, applying an ink to said substrate, and removing said foraminous substrate to leave an image on said surface.

8. The method of claim 7 wherein said cross-linkable polymeric substance comprises gelatine.

9. The method of claims 7 or 8 wherein said foraminous member comprises a cloth or screen.

10. The method according to any of claims 7 to 9 wherein said cross-linkable polymeric substance is selected from at least one of the group consisting of polymers of acrylic, methacrylic, maleic acid, maleic anhydride and their copolymers with ethylene, styrene or vinyl-ethers.
